# EUROPEAN PATENT APPLICATION

(11) **EP 4 379 783 A1**
(43) Date of publication of application: **05.06.2024**
(21) Application number: 22210278.2
(22) Date of filing: 29.11.2022
(51) Int. Cl.: H01L 21/683, H01L 21/687

(54) **ELECTROSTATIC CLAMP, GRIPPER ASSEMBLY INCLUDING THE CLAMP, LITHOGRAPHIC SYSTEM COMPRISING AN ELECTROSTATIC CLAMP, AND METHOD OF MAKING AN ELECTROSTATIC CLAMP**

(71) Applicant: ASML Netherlands B.V., 5500 AH Veldhoven (NL)
(72) Inventor: POIESZ, Thomas, 5500 AH Veldhoven (NL); STEIN, Alexander, 5500 AH Veldhoven (NL); VAN ROOIJ, René Adrianus, 5500 AH Veldhoven (NL)
(74) Representative: ASML Netherlands B.V.

(57) **Abstract**

The disclosure provides an electrostatic clamp for clamping an object, comprising: an electrode layer; a first isolating layer comprising an electrically isolating flexible material arranged on top of the electrode layer, the first isolating layer having a first thickness; a first shielding layer comprising an electrically conductive material arranged on top of the first isolating layer, the first shielding layer having a first shielding thickness and a cut-out pattern for exposing the electrode layer covered with the first isolating layer; and a number of burls of at least 1 µm tall arranged on top of the first shielding layer at the location of the cut-out pattern.

## Description

### FIELD

The present invention relates to an electrostatic clamp. The invention also relates to a method of making the clamp, and to a method of using the clamp for holding an object. The object may be, for example, a substrate for a lithographic process such as a wafer, reticle, or mask. The clamp may be included in, for instance, a robotic arm for transporting the object from one location to another.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

An electrostatic chuck typically holds and supports a substrate during a lithographic manufacturing process and also removes heat from the substrate without mechanically clamping the substrate. During use of an electrostatic chuck, the back side of a substrate, such as a semiconductor wafer, is held to the face of the electrostatic chuck by an electrostatic force. The substrate is separated from one or more electrodes in the face of the electrostatic chuck by a surface layer of material that covers the electrode. In a Coulombic chuck, the surface layer is electrically insulating, while in a Johnsen-Rahbek electrostatic chuck, the surface layer is weakly conducting. The surface layer of the electrostatic chuck may be flat or may have one or more protrusions, projections or other surface features that further separate the back side of the substrate from the covered electrode. Heat delivered to the substrate during processing can be transferred away from the substrate and to the electrostatic chuck, for example by contact heat conduction with the protrusions and/or by gas heat conduction with a cooling gas.

In microelectronics production, as semiconductor and memory device geometries become progressively smaller and the sizes of wafers, flat screen displays, reticles and other processed substrates become progressively larger, the allowable particulate contamination process specifications become more restrictive. The effect of particles on electrostatic chucks is of particular concern because the wafers physically contact or mount to the chuck clamping surface. If the mounting surface of the electrostatic chuck allows any particulate to become entrapped between the mounting surface and the substrate, the substrate may be deformed by the entrapped particle. For example, if the back side of a wafer is clamped electrostatically against a flat reference surface, the entrapped particle could cause a deformation of the front side of the wafer, which will therefore not lie in a flat plane. The actual height and diameter of the particle-induced displacement is dependent on numerous parameters such as the particle size, the particle hardness, the clamping force and the reticle thickness.

A robot gripper may also include electrostatic clamps. The robot gripper may typically be included in a wafer handler. A wafer handler is a device that can be used to transfer substrates, such as wafers, masks and the like, from one location to another.

The electrostatic clamps of the robot gripper may be made using comparable technology as the electrostatic clamp of the wafer stage. However, the manufacturing technology to make the robot gripper clamps is typically unsuitable to sufficiently balance the requirements of the gripper assembly thereof. These requirements may include potential for an anodic bond, ability to withstand HF etching, and ability to handle warped substrates within a certain range. Also, the wafer handler clamps have to operate at a significantly lower voltage than the wafer stage clamps (for instance at about 1.6kV instead of 3.2kV). As a consequence, electrostatic clamps of the wafer gripper tend to have a relatively limited tolerance for warped substrates, increasing the risk of substrate slip. Substrate slip herein refers to a substrate, such as a wafer, slipping from the grip of the handler and falling. The latter typically results in loss of the respective substrate, thus reducing output.

The current clamps are rigid (due to glass construction) and may be warped up to 40 µm over the width of one clamp (having a diameter of about 40 mm). The clamping pressure is insufficient to flatten the clamp against the wafer (against flat wafers, let alone warped wafers). With a vacuum gap designed at a lower limit in the order of, for example, 10 um, in practice each clamp makes only three-burl contact and the average vacuum gap may be (much) lower than the preferred setting, reducing the actual clamping pressure below the design specifications expected for a certain voltage. This may result in slip of the clamps of the robot gripper with respect to the wafer, and thus damage of the burls and wafer, limiting lifetime and creating contamination. Consequential damage relates to reduced availability (uptime).

US 2012/0196242 discloses a substrate support that may include a plurality of substrate support pins. The plurality of substrate support pins can support a backside surface of the substrate. In some embodiments, a support layer may be disposed on the first surface of the first member and each of the plurality of substrate support pins may extend from a surface of the support layer. In some embodiments, the support layer and the each of the plurality of substrate support pins may be formed from the same material. For example, the support layer and the each of the substrate support pins may be a one-piece structure. The support layer and each of the plurality of substrate support pins can be formed of suitable process-compatible materials having wear resistant properties. For example, materials may be compatible with the substrate, with processes to be performed on the substrate, or the like. In some embodiments, the support layer and/or the substrate support pins may be fabricated from a dielectric material. In some embodiments, the materials used to form the support layer and/or the substrate support pins may include one or more of a polyimide (such as KAPTON^{®}), aluminum oxide (Al2O3), aluminum nitride (A1N), silicon dioxide (SiO2), silicon nitride (Si3N4), or the like. In some embodiments, for example for low temperature applications (e.g., at temperatures below about 200 degrees Celsius), the support layer and/or the substrate support pins may comprise KAPTON^{®}.

DE102004059122A1 discloses an electrostatic holder (EC), e.g. to secure a thin semiconductor wafer to a surface, has an array of electrically conductive electrodes (E) and a dielectric to insulate the electrodes from the wafer at least at the holding surface. An electrically conductive and elastic layer at the electrode array allows for movement shifts (delta T) through thermal expansion without wafer surface damage.

Although the electrostatic holder of DE102004059122A1 and the substrate support of US2012/0196242 may work well for some applications, like other conventional systems they have proven to be unsuitable for application in clamps of a robot gripper.

### SUMMARY

The present disclosure aims to provide an improved electrostatic clamp, alleviating at least some of the disadvantages referenced above. It is an aim to provide an improved clamp suitable for a wafer handler, with ability to handle a wider range of substrates.

The disclosure provides an electrostatic clamp for clamping an object, comprising:
an electrode layer;
a first isolating layer comprising an electrically isolating flexible material arranged on top of the electrode layer, the first isolating layer having a first thickness;
a first shielding layer comprising an electrically conductive material arranged on top of the first isolating layer, the first shielding layer having a first shielding thickness and a cut-out pattern for exposing the first isolating layer; and
a number of burls with a height between 1 µm and 50 µm arranged on top of the first shielding layer at the location of the cut-out pattern, wherein the burls are electrically connected to the first shielding layer.

In an embodiment, the electrode layer being arranged on a second isolating layer.

In an embodiment, the electrostatic clamp comprising a second shielding layer comprising an electrically conductive material arranged on the second isolating layer; and a third isolating layer arranged on the second shielding layer.

In an embodiment, the electrostatic clamp comprises an electrical connection connecting the first shielding layer and/or the second shielding layer for earth, and connecting the electrode layer to a voltage source.

In an embodiment, the electrically conductive material of the second layer comprises chromium nitride (CrN); and/or the burls are made of a material comprising chromium nitride (CrN).

In an embodiment, the flexible material of the first isolating layer comprises Kapton^{®}.

In an embodiment, the second thickness is in the range of 0.5 to 10 µm; and/or the first thickness is in the range of 50 to 250 µm.

According to another aspect, the disclosure provides a gripper assembly for transferring an object from one location to another, the gripper assembly comprising:
a support structure,
a laminate of layers arranged on the support structure, the laminate comprising at least:
   an electrode layer;
   a first isolating layer comprising an electrically isolating flexible material arranged on top of the electrode layer, the first isolating layer having a first thickness;
   a first shielding layer comprising an electrically conductive material arranged on top of the first isolating layer, the first shielding layer having a first shielding thickness and a cut-out pattern for exposing the first isolating layer; and
   a number of burls with a height between 1 µm and 50 µm arranged on top of the first shielding layer at the location of the cut-out pattern.

In an embodiment, the laminate further comprising a second isolating layer comprising an electrically isolating flexible material, the electrode layer being arranged on the second isolating layer.

In an embodiment, the laminate further comprises:
a second shielding layer of an electrically conductive material arranged on the second isolating layer; and
a third isolating layer arranged on the second shielding layer.

In an embodiment, the support structure comprises a number of fingers, each finger having an end provided with one of the at least one cut-out patterns.

In an embodiment, the support structure comprises at least one opening, each at least one cut-out pattern covering a respective opening.

In an embodiment, the support structure has three fingers, each finger having an end provided with a respective opening.

In an embodiment, a damping material is arranged in the at least one opening.

In an embodiment, the laminate extends from one end of the support structure, said one end being provided with the at least one cut-out pattern, to a second end, said second end being provided with an electrical connector, wherein at least the electrode layer and the first shielding layer are electrically connected to the electrical connector.

In an embodiment, the electrically conductive material comprising chromium nitride (CrN); and/or wherein the burls are made of a material comprising chromium nitride (CrN).

In an embodiment, the flexible material comprises Kapton^{®}.

In an embodiment, the second thickness is in the range of 0.5 to 10 µm; and/or the first thickness is in the range of 50 to 250 µm.

According to yet another aspect, the disclosure provides a lithographic system comprising at least one electrostatic clamp or a gripper assembly as described above.

According to another aspect, the disclosure provides a method of making a gripper assembly including an electrostatic clamp, the method comprising the steps of:
providing a support structure,
manufacturing a laminate of layers, the laminate comprising at least:
   providing an electrode layer;
   arranging a first layer of an electrically isolating flexible material on top of the electrode layer, the first layer having a first thickness;
   arranging a first shielding layer comprising an electrically conductive material on top of the first isolating layer, the first shielding layer having a first shielding thickness and at least one cut-out pattern for exposing the first isolating layer;
   providing a number of burls of at least 1 µm tall on top of the first shielding layer at the location of the cut-out pattern; and
   arranging the laminate on the support structure.

In an embodiment, the step of manufacturing a laminate further comprises:
arranging a second isolating layer comprising an electrically isolating flexible material on the electrode layer;
arranging a second shielding layer of an electrically conductive material on the second isolating layer; and
arranging a third isolating layer on the second shielding layer.

In an embodiment, the method comprises the steps of:
providing the support structure with at least one opening; and
covering the at least one opening with a clamp section of the laminate, the clamp section comprising the cut-out pattern.

In an embodiment, the method comprises the step of arranging a damping material in the at least one opening.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 depicts a perspective view of an example of a conventional gripper assembly;
- Figure 3 depicts a schematic top view of an embodiment of an electrostatic clamp according to the present disclosure;
- Figure 4 depicts a schematic side view of an embodiment of an electrostatic clamp according to the present disclosure;
- Figures 5A to 5G depict a top view of respective layers an embodiment of an electrostatic clamp according to the present disclosure;
- Figure 5H depicts a top view of an alternative embodiment of the layer shown in Figure 5D; and
- Figure 6 depicts an exploded perspective view of stacked layers an embodiment of an electrostatic clamp;
- Figure 7 depicts a schematic side view of an embodiment of an electrostatic clamp according to the present disclosure included in a gripper assembly;
- Figure 8 depicts a schematic side view of another embodiment of an electrostatic clamp according to the present disclosure included in a gripper assembly; and
- Figure 9 depicts a perspective view of an embodiment of a gripper assembly according to the present disclosure.

### DETAILED DESCRIPTION

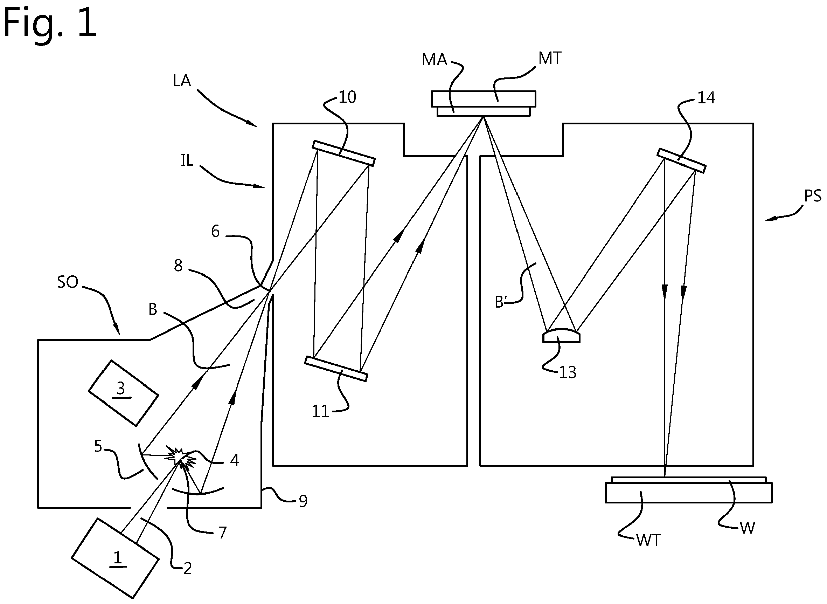

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

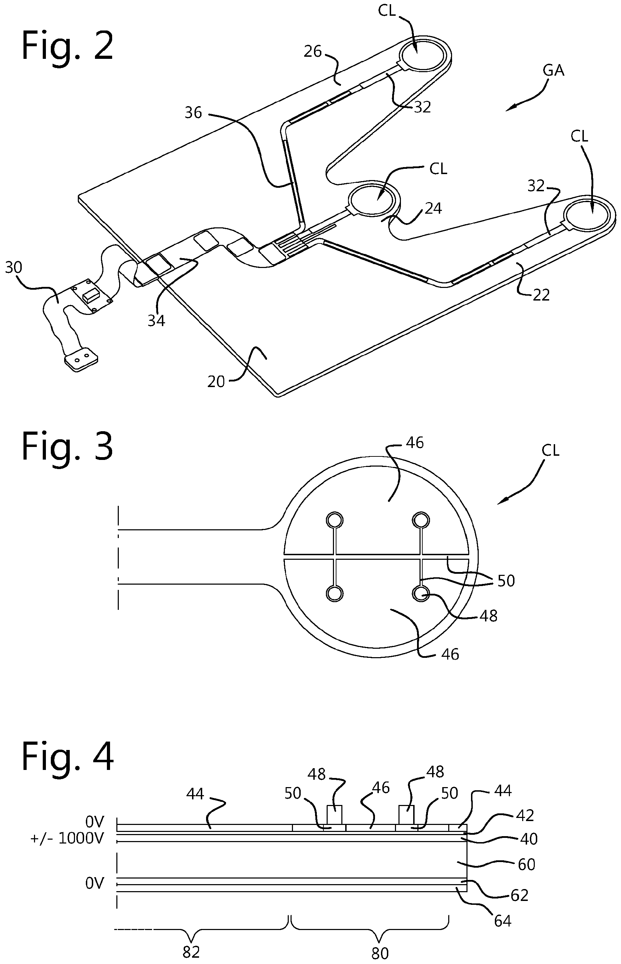

Figure 2 shows an example of a gripper assembly GA for transferring an object from one location to another. The object can be a substrate. A substrate herein may include, but is not limited to, a wafer, a reticle, and a mask. The respective locations may be inside the lithographic apparatus LA, but may also be outside of the apparatus. I.e. the gripper assembly may be part of a substrate handler for transferring a substrate from outside the lithographic apparatus to inside the apparatus, and vice versa. Typically, the lithographic apparatus includes an airlock to transfer substrates from an atmospheric environment to a vacuum environment inside the lithographic apparatus.

The gripper assembly GA typically comprises a support structure 20 provided with one or more electrostatic clamps CL for holding the substrate. The support structure 20 may comprise one or more fingers 22, 24, 26 extending outward from a main body 28 of the support structure. Each finger may be provided with a respective clamp CL. The clamps may be arranged ta ends of the respective finger.

For instance, conventional electrostatic clamps may include burls made of anodically bonded glass with a chrome electrode sandwiched in between. The glass burls can be etched on top of the electrode to keep the distance between the wafer and clamp constant and allow particles therein between without disturbing the lithographic process. Conventionally, each clamp is connected to a flexible power cable 30 via an electrical connector 32 and a power line 34. The power cable 30 is arranged to provide a high voltage to the electrostatic clamps. The power line has branches 36 extending to respective electrostatic clamps.

A problem with the conventional setup relates to the electrical connectors 32, which are relatively fragile. The connectors 32 connect a source of high voltage to a conducting layer having a thickness in the order of 100 nm. Consequently, the connectors 32 are cumbersome to make, and easily break down.

As a solution, the electrostatic clamps, optionally including the power lines 34, 36 and optionally also (at least part of) the power cable 30 can be constructed using an embodiment of an electrostatic clamp as described herein below. Thus, the electrostatic clamps can be made as a laminate. The laminate may constitute an electrostatic clamp as well as the related power cable and its branches. This obviates the construction of fragile electrical connectors, reduces chance of failure, and greatly simplifies and accelerates construction, thereby reducing associated costs.

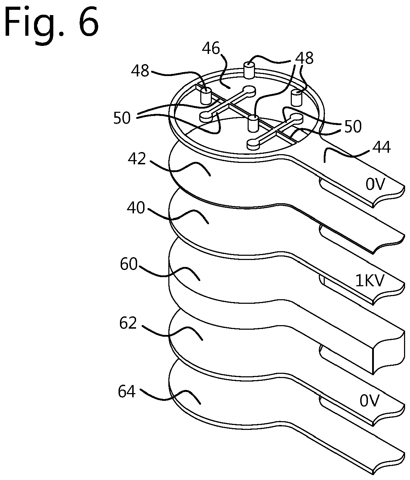

Generally referring to Figures 3, 4, 5 and 6, an electrostatic clamp CL for clamping a substrate may comprise a laminate comprising a number of stacked layers. The electrostatic clamp CL comprises an electrode layer 40. A first isolating layer 42 comprising an electrically isolating flexible material is arranged on top of the electrode layer 40. The first isolating layer has a first thickness. A first shielding layer 44 of an electrically conductive material is arranged on top of the first isolating layer 42. The first shielding layer has a first shielding thickness. The first shielding layer 44 is provided with a cut-out pattern 46 for exposing the electrode layer covered with the first isolating layer. See for instance Figure 3.

A number of burls 48 is arranged on top of the first shielding layer 44 at the location of the cut-out pattern 46. The phrase at the location of the cut-out pattern herein means that the burls 48 are arranged on top of the conductive material of the first shielding layer. The burls 48 may be at least partially surrounded by the cut-out pattern 46. Typically, the burls may be comprised of an electrically conductive material. Said material may be the same material as the conductive material of the conductive layer 44. The term "burls" herein may relate to, for instance, piles, columns, or raised structures.

The burls may have a height between 1 µm and 50 µm, preferably between 2 µm and 20 µm, more preferably between 5 µm and 12 µm. Although Figure 3 shows four burls, the clamp CL may comprise any number of burls suitable for supporting a substrate. The clamp CL may include, for instance, at least three burls. In a practical embodiment, the electrostatic clamp may include in the range of about 10 to 100 burls, for instance about 20 to 50 burls.

The cut-out pattern 46 of the conductive material of the first shielding layer 44 provides a pattern of lines 50. The pattern may be a Manhattan pattern. Alternative patterns are also conceivable. The burls 48 may be electrically connected to each other and to the first shielding layer 44 (via the lines 50).

In an embodiment, the laminate of the electrostatic clamp CL may comprise additional layers. The laminate of layers may include a second isolating layer 60. The second isolating layer 60 may be arranged adjacent the electrode layer on an opposite side to the first isolating layer 42. The laminate of the electrostatic clamp CL may include a second shielding layer 62. The second shielding layer typically comprises a conductive material. The second shielding layer 62 may be covered by a third isolating layer 64.

The electrode layer can be connected to a voltage source. The voltage source may typically provide a high voltage, in the order of 1 to 3 kV. The first shielding layer and the second shielding layer can be connected to ground, 0 V, thereby shielding the electric field created by the electrode layer 42.

The conductive material of the electrode layer 42 and/or the second shielding layer may comprise a metal, such as copper, iron, iron composites, titanium, silver, gold, etc. Combinations of metals are also conceivable.

The first, second and third isolating layers 42, 60, 64 may comprise a suitable isolating polymer. The polymer of all isolating layers may be the same. Alternatively, a different isolating material may be used for each isolating layer. See below for details of a practical embodiment.

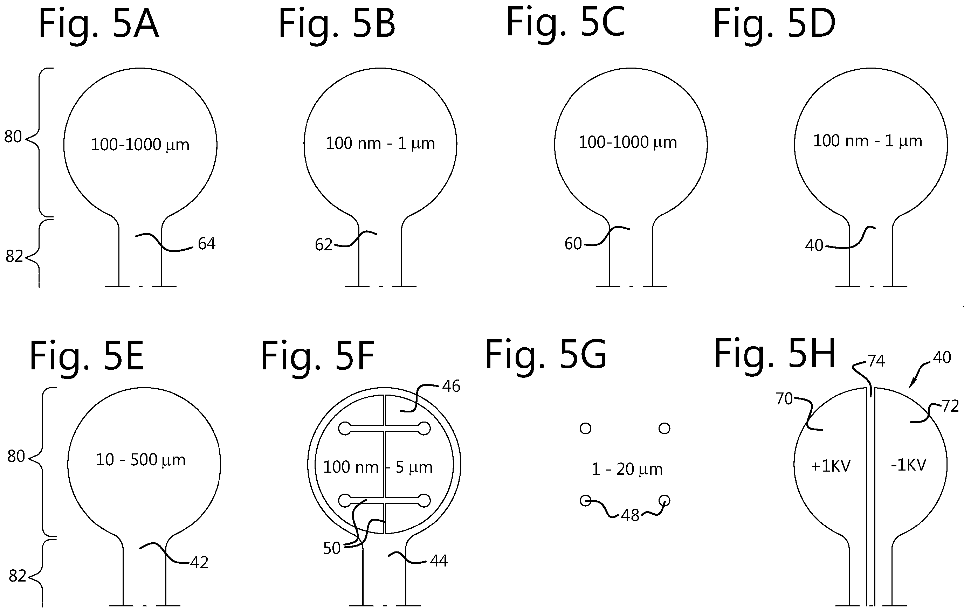

In an alternative embodiment, see Figure 5H, the electrode layer 40 may comprise a first section 70 and a second section 72, arranged at a mutual spacing 74. The spacing 74 is preferably sufficient to allow a voltage differential across the first and second sections 70, 72. For instance, during use of the electrostatic clamp, the first section may operate at a positive voltage while the second section 72 may operate at a negative voltage, or vice versa. The positive voltage may be in the range of 0.5 to 3 kV, for instance about 1 kV. The negative voltage may be in the range of -0.5 to -3 kV, for instance about -1 kV.

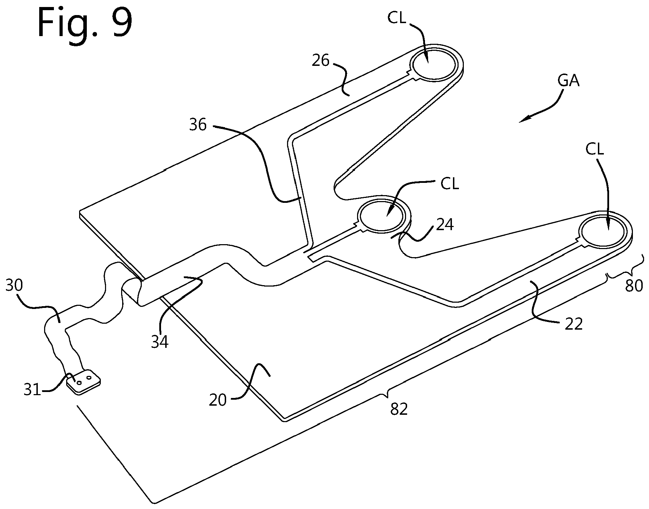

Referring to Figures 3 to 6, the respective layers of the electrostatic clamp CL of the present disclosure may comprise a clamp section 80. Stacked, the respective layers as described above, and as exemplified in the Figures, can operate as an electrostatic clamp CL. The respective layers may also include a cabling section 82. Shown in part only in the Figures 3 to 6, said cabling section 82 may extend as far and along any path of choice. Referring to Figure 9, the cabling section 82 of the respective layers may, in combination, form the branches 36 and optionally also the cable connection section 34 and optionally also (at least part of) the flexible cable 30. A connector 31 may be provided at the end of the cable 30, allowing connection to, for instance, a voltage source.

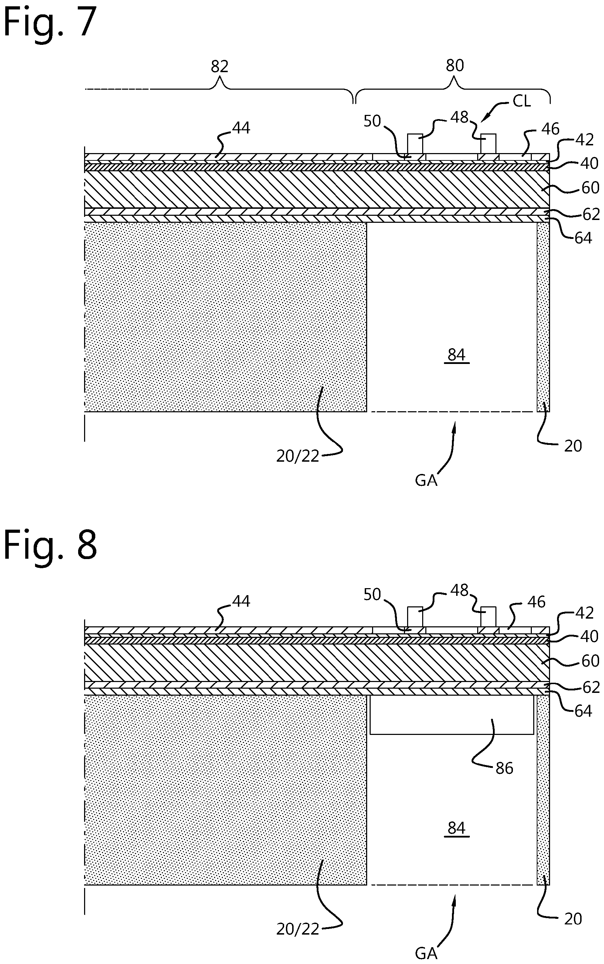

Referring to Figure 7, the support structure 20 is provided with one or more openings 84. Typically, at least one opening 84 may be provided at an end of respective fingers 22, 24, 26 of the support structure 20. The laminate of layers as described with respect to Figures 3 to 6 is arranged on the support structure 20. Herein, the clamp section 80 may be arranged covering the at least one opening 84. Thus, the cable section 82 can be supported by the support structure 20, while the clamp section 80 is at least in part freely suspended over the opening 84. The suspended clamp section may be mounted like a membrane, allowing increased compliancy to substrate shapes

Generally referring to Figure 8, in an embodiment, the at least one opening 84 may be provided with a piece of damping material 86. The damping material may comprise a visco-elastic material. The material may be an elastomer, for instance a high-performance fluoroelastomer such as Viton^{™}. The damping material will dampen vibrations in the substrate.

The inherent flexibility of the one or more isolating and flexible layers 42, 60, 64 in combination with the relatively thin shielding layers and the electrode layer allows the laminate structure to be flexible and function as a cable for transferring voltage to the clamp. Thus, the laminate functions as power cable, optionally provided with a connector, and as an electrostatic clamp connected to the cable. See Figure 9 for an example. Herein, the laminate having clamp section 80 and cable section 82 is arranged on the support structure 20. The connector 31 can be provided at the end of the cable section 82.

The laminate, optionally including the connector 31, can be constructed in its entirety, and then be arranged on the support structure 20 of the gripper assembly. This obviates failure prone and difficult to make high voltage connections to layers of about 100 nm thick. As an alternative, the laminate may be fabricated, be arranged on the support structure 20, and then the burls may be provided.

One of the drivers of the electrostatic clamp of the present disclosure is that the technology of making flexible cables is relatively cheap, fast and reliable. The technique to make flexible cables is known from production of electronic components. Current manufacturing equipment allows perfect dimensional precision, electrical resistance control and production of long continuous lengths.

In a first step, respective layers 40, 42, 60, 62, and 64 are positioned on top of each other and joined, to form a laminate of layers. Joining respective layers can be done using, for instance, temperature forming.

In a subsequent step, the laminate of layers is cut in a predetermined shape. Cutting the shape can be done using, for instance, laser cutting.

The laser cutting step can be combined with a step to deposit a coating to form the shielding layer 44 and/or the burls 48. Depositing herein may include, for instance, physical vapor deposition (PVD), triode sputtering, magnetron sputtering or ion beam assisted deposition (IBAD). Alternatively, depositing the coating may involve a lithographic process involving resist to create the pattern 46 and deposit the material of the coating.

Next, the connector 31 can be connected to the laminate.

Subsequently, the laminate can be applied onto the support structure 20 of the gripper assembly GA (Fig. 9).

Compared to the conventional method of connecting the clamps, as described with reference to Figure 2, the method to manufacture a gripper assembly provided with one or more electrostatic clamps according to the present disclosure is very fast and cheap.

The layers between the outer layers 44, 64 are all uniform, having the same shape. This includes the electrode layer.

The isolating layer 42 below the shielding layer 44, together with the burls 48, defines the electrostatic field strength. The material of the isolating flexible layer 42 acts as a di-electric. The burls define the distance between the substrate resting on top of the burls and the electrode. The voltage of the electrode layer can be controlled.

The cut-out pattern 46 of the structured layer 44 defines the electrostatic clamping functionality of this layer.

The burls 48 may be hard masked, or may be made entirely from relatively hard and wear-resistant material. The burls provide a relatively fast and cheap but robust way of defining the gap between the dielectric of layer 42 and the substrate wafer (and thus the clamping force).

The clamp may comprise an electrical connection connected to the second patterned layer 44. The electrical connection may allow a predetermined electrical potential of the conductive layer 44. The line pattern 50 made of conductive material connects the burls 48 to the predetermined electrical potential. Said electrical potential is typically ground or earth, a reference value determined as 0V. Thus, the conductive layer 44 can act as a shielding layer, shielding the electrical potential of the electrode layer 40. Only at the location of the openings of the cut-out pattern 46 the electrode layer is exposed, allowing the electrical field thereof to provide an electrostatic clamping force.

The electrode layer 40 can be connected to a voltage potential. Said voltage potential may typically be a high voltage in the order of, for instance, 0.5 kV or more. In a practical embodiment, the voltage may be in the range of about 1 kV to 3.5 kV.

The isolating layer 42 covering the electrode layer herein may act as a di-electric. A dielectric is an insulating material or a very poor conductor of electric current. When dielectrics are placed in an electric field, practically no current flows in them because they have no free electrons that may drift through the material. Instead, electric polarization occurs. The positive charges within the dielectric are displaced minutely in the direction of the electric field, and the negative charges are displaced minutely in the direction opposite to the electric field. This slight separation of charge, or polarization, reduces the electric field within the dielectric.

The electrically conductive material of the second layer 44 may be made of a wear resistant and electrically conductive material. The second layer may be applied as a coating. The second layer may comprise chromium nitride (CrN).

The burls can be made of the same material as the conductive layer 44. The burls may be made of a material comprising chromium nitride (CrN).

The CrN included in the electrostatic clamp of the disclosure is preferably conductive. Conductivity of the CrN may be controlled, for instance, by adjusting the amount of chromium with respect to the amount of nitride. In a practical embodiment, the conductive shielding layers comprising CrN have a total resistance not exceeding 250 Ohm from CrN coating to the electrical connection cable 30. Measurement points herein are across the entire CrN coating 44. Typical resistance of the conductive coating is, for instance, around 10 to 30 Ohm. For the burls made of CrN, the resistance value can go to 100 to 400 Ohm.

In a practical embodiment, the resistivity of the conductive material of the coating layer 44, such as CrN, may be in the range of 10 Ohm^{∗}m to 5000 Ohm^{∗}m. Resistivity, commonly symbolized by the Greek letter rho (p), is quantitatively equal to the resistance R of a specimen such as a coating, multiplied by its cross-sectional area A, and divided by its length 1, so p = RA/1. The unit of resistivity is Ohm^{∗}m. Insulators have high values of electrical resistivity, typically in the order of 10¹⁰ Ωm or more. In contrast, (metal) conductors may have very small resistivity values, for instance in the order of 10⁻⁸ Ωm.

The flexible isolating material of the first isolating layer 42, the second isolating layer 60, and/or the third isolating layer may comprise polyimide (PI), a polymer containing imide groups belonging to the class of high-performance plastics. In a practical embodiment, the isolating flexible material comprises, or is made of, Kapton^{®}, a class of polyimide. The flexible material of the first isolating layer 42, the second isolating layer 60, and/or the third isolating layer 64 may have, but is not limited to, for instance, one or more properties in the order of: Young's modulus about 2.5 to 5 GPa, for instance about 4 GPa; Tensile strength about 80 to 90 MPa; Elastic range or Elongation in the elastic range about 4 to 5%; Compressive strength about 150 to 180 MPa; Fatigue about 15 to 30 MPa; Bending strength about 100 to 130, for instance about 115 MPa; and/or Poisson's ratio about 0.3 to 0.35, for instance about 0.34.

In a practical embodiment, the layers may have a thickness in a certain range. The second thickness of the second layer 44 may be in the range of 0.5 to 10 µm. The first thickness of the first insulating layer 42 may be in the range of 50 to 250 µm. The electrode layer 40 may have a thickness in the range of 0.1 to 1 µm. The one or more burls 48 may have a height in the range of 1 to 20 µm.

The thickness of the second insulating layer 60 may be in the range of 100 µm to 1 mm. The thickness of the third insulating layer 64 may be in the range of 100 µm to 1 mm. The second coating thickness of the second shielding layer 62 may be in the range of 0.1 to 1 µm.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Examples
1. An electrostatic clamp for clamping an object, comprising:
   an electrode layer;
   a first isolating layer comprising an electrically isolating flexible material arranged on top of the electrode layer, the first isolating layer having a first thickness;
   a first shielding layer comprising an electrically conductive material arranged on top of the first isolating layer, the first shielding layer having a first shielding thickness and a cut-out pattern for exposing the first isolating layer; and
   a number of burls of at least 1 µm tall arranged on top of the first shielding layer at the location of the cut-out pattern.
2. The electrostatic clamp of example 1, the electrode layer being arranged on a second isolating layer.
3. The electrostatic clamp of example 2, comprising:
   a second shielding layer comprising an electrically conductive material arranged on the second isolating layer; and
   a third isolating layer arranged on the second shielding layer.
4. The electrostatic clamp of one of the previous examples, comprising:
   an electrical connection connecting the first shielding layer and/or the second shielding layer for earth, and connecting the electrode layer to a voltage source.
5. The electrostatic clamp of one of the previous examples,
   wherein the electrically conductive material of the second layer comprises chromium nitride (CrN); and/or
   wherein the burls are made of a material comprising chromium nitride (CrN).
6. The electrostatic clamp of one of the previous examples, wherein the flexible material of the first layer comprises Kapton^{®}.
7. The electrostatic clamp of one of the previous examples,
   wherein the second thickness is in the range of 0.5 to 10 µm; and/or
   wherein the first thickness is in the range of 50 to 250 µm.
8. Gripper assembly for transferring an object from one location to another, the gripper assembly comprising:
   a support structure,
      a laminate of layers arranged on the support structure, the laminate comprising at least:
      an electrode layer;
   a first isolating layer comprising an electrically isolating flexible material arranged on top of the electrode layer, the first isolating layer having a first thickness;
   a first shielding layer comprising an electrically conductive material arranged on top of the first isolating layer, the first shielding layer having a first shielding thickness and a cut-out pattern for exposing the first isolating layer; and
      a number of burls of at least 1 µm tall arranged on top of the first shielding layer at the location of the cut-out pattern.
9. The gripper assembly of example 8, the laminate further comprising a second isolating layer comprising an electrically isolating flexible material, the electrode layer being arranged on the second isolating layer.
10. The gripper assembly of example 9, the laminate further comprising:
   a second shielding layer of an electrically conductive material arranged on the second isolating layer; and
   a third isolating layer arranged on the second shielding layer.
11. The gripper assembly of one of examples 8 to 10, wherein the support structure comprises a number of fingers, each finger having an end provided with one of the at least one cut-out patterns.
12. The gripper assembly of one of examples 8 to 11, wherein the support structure comprises at least one opening, each at least one cut-out pattern covering a respective opening.
13. The gripper assembly of example 12, wherein the support structure has three fingers, each finger having an end provided with a respective opening.
14. The gripper assembly of example 12 or 13, wherein a damping material is arranged in the at least one opening.
15. The gripper assembly of one of examples 8 to 14, wherein the laminate extends from one end of the support structure, said one end being provided with the at least one cut-out pattern, to a second end, said second end being provided with an electrical connector, wherein at least the electrode layer and the first shielding layer are electrically connected to the electrical connector.
16. The gripper assembly of one of examples 8 to 15, the electrically conductive material comprising chromium nitride (CrN); and/or wherein the burls are made of a material comprising chromium nitride (CrN).
17. The gripper assembly of one of examples 8 to 16, wherein the flexible material comprises Kapton^{®}.
18. The gripper assembly of one of examples 8 to 17,
   wherein the second thickness is in the range of 0.5 to 10 µm; and/or
   wherein the first thickness is in the range of 50 to 250 µm.
19. A lithographic system comprising at least one electrostatic clamp according to example 1 or a gripper assembly according to example 8.
20. A method of making a gripper assembly including an electrostatic clamp, the method comprising the steps of:
   providing a support structure,
   manufacturing a laminate of layers, the laminate comprising at least:
      providing an electrode layer;
         arranging a first layer of an electrically isolating flexible material on top of the electrode layer, the first layer having a first thickness;
      arranging a first shielding layer comprising an electrically conductive material on top of the first isolating layer, the first shielding layer having a first shielding thickness and at least one cut-out pattern for exposing the first isolating layer;
      providing a number of burls of at least 1 µm tall on top of the first shielding layer at the location of the cut-out pattern; and
      arranging the laminate on the support structure.
21. The method of example 20, wherein the step of manufacturing a laminate further comprises:
   arranging a second isolating layer comprising an electrically isolating flexible material on the electrode layer;
   arranging a second shielding layer of an electrically conductive material on the second isolating layer; and
   arranging a third isolating layer on the second shielding layer.
22. The method of one of examples 20 or 21, comprising the steps of:
   providing the support structure with at least one opening; and
   covering the at least one opening with a clamp section of the laminate, the clamp section comprising the cut-out pattern.
23. The method of example 22, comprising the step of arranging a damping material in the at least one opening.

## Claims

1. An electrostatic clamp for clamping an object, comprising:
an electrode layer;
a first isolating layer (42) comprising an electrically isolating flexible material arranged on top of the electrode layer, the first isolating layer having a first thickness;
a first shielding layer (44) comprising an electrically conductive material arranged on top of the first isolating layer, the first shielding layer having a first shielding thickness and a cut-out pattern for exposing the first isolating layer; and
a number of burls (48) with a height between 1 µm and 50 µm arranged on top of the first shielding layer.

2. The electrostatic clamp of claim 1, wherein the burls are at least partially surrounded by the cut-out pattern or/and wherein the burls are electrically connected to each other and to the first shielding layer.

3. The electrostatic clamp of claim 2, wherein the electrode layer being arranged on a second isolating layer, the electrostatic clamp further comprising:
a second shielding layer comprising an electrically conductive material arranged on the second isolating layer; and
a third isolating layer arranged on the second shielding layer.

4. The electrostatic clamp of one of the previous claims, comprising:
an electrical connection connecting the first shielding layer and/or the second shielding layer for grounding, and connecting the electrode layer to a voltage source.

5. The electrostatic clamp of one of the previous claims,
wherein the electrically conductive material of the second layer comprises chromium nitride (CrN); and/or
wherein the burls comprises chromium nitride (CrN).

6. The electrostatic clamp of one of the previous claims, wherein the flexible material of the first isolating layer comprises Kapton^{®}.

7. The electrostatic clamp of one of the previous claims,
wherein the first shielding thickness is in the range of 0.5 to 10 µm; and/or
wherein the first thickness is in the range of 50 to 250 µm.

8. Gripper assembly for transferring an object from one location to another, the gripper assembly comprising:
a support structure,
a laminate of layers arranged on the support structure, the laminate comprising at least:
an electrode layer;
a first isolating layer comprising an electrically isolating flexible material arranged on top of the electrode layer, the first isolating layer having a first thickness;
a first shielding layer comprising an electrically conductive material arranged on top of the first isolating layer, the first shielding layer having a first shielding thickness and a cut-out pattern for exposing the first isolating layer; and
a number of burls (48) with a height between 1 µm and 50 µm arranged on top of the first shielding layer.

9. The gripper assembly of claim 8, the laminate further comprising a second isolating layer comprising an electrically isolating flexible material, the electrode layer being arranged on the second isolating layer.

10. The gripper assembly of claim 9, the laminate further comprising:
a second shielding layer of an electrically conductive material arranged on the second isolating layer; and
a third isolating layer arranged on the second shielding layer.

11. The gripper assembly of one of claims 8 to 10, wherein the support structure comprises a number of fingers, each finger having an end provided with one of the at least one cut-out patterns.

12. The gripper assembly of one of claims 8 to 11, wherein the support structure comprises at least one opening, each at least one cut-out pattern covering a respective opening.

13. The gripper assembly of claim 12, wherein the support structure has three fingers, each finger having an end provided with a respective opening.

14. A lithographic system comprising at least one electrostatic clamp according to claim 1 or a gripper assembly according to claim 8.

15. A method of making a gripper assembly including an electrostatic clamp, the method comprising the steps of:
providing a support structure,
manufacturing a laminate of layers, the laminate comprising at least:
providing an electrode layer;
arranging a first layer of an electrically isolating flexible material on top of the electrode layer, the first layer having a first thickness;
arranging a first shielding layer comprising an electrically conductive material on top of the first isolating layer, the first shielding layer having a first shielding thickness and at least one cut-out pattern for exposing the first isolating layer;
providing a number of burls with a height between 1 µm and 50 µm arranged on top of the first shielding layer; and
arranging the laminate on the support structure.
